# NEUE EUROPÄISCHE PATENTSCHRIFT

(11) **EP 2 426 569 B2**
(45) Veröffentlichungstag und Bekanntmachung des Hinweises auf die Entscheidung über den Einspruch: **13.03.2019**
(45) Hinweis auf die Patenterteilung: 18.03.2015
(21) Anmeldenummer: 11179732.0
(22) Anmeldetag: 01.09.2011
(51) Int. Cl.: G05D 23/19, H01L 35/32, H01L 35/30

(54) **Thermoelektrische Vorrichtung zum Erzeugen von elektrischer Energie**
Thermoelectric device for generating electrical energy
Dispositif thermoélectrique pour la production d'énergie électrique

(30) Priorität: 01.09.2010 DE 102010040107
(43) Veröffentlichungstag der Anmeldung: 07.03.2012
(73) Patentinhaber: Micropatent B.V., 7609 PK Almelo (NL)
(72) Erfinder: Volkert, Fritz, 4104 Oberwil (CH); Nurnus, Joachim, 79395 Neuenburg (DE); Benkendorf, Mike, 79110 Freiburg (DE)
(74) Vertreter: Maikowski & Ninnemann Patentanwälte Partnerschaft mbB

(56) Entgegenhaltungen:
- EP-A1- 1 729 195
- WO-A2-2009/106431
- DE-B3-102006 006 999
- DE-B4- 10 065 098
- DE-C2- 3 020 835
- DE-C2- 3 153 654
- GB-A- 2 216 293
- US-A- 6 105 373

## Beschreibung

Die Erfindung betrifft eine thermoelektrische Vorrichtung zum Erzeugen von elektrischer Energie gemäß Anspruch 1.

Aus dem Stand der Technik sind thermoelektrische Vorrichtungen zur Umwandlung von Wärmeenergie in elektrische Energie bekannt. Beispielsweise weisen derartige Vorrichtungen Thermogeneratoren auf, die unter Einwirkung eines Temperaturgradienten gemäß dem Seebeck-Effekt eine elektrische Spannung erzeugen.

Beispielsweise ist aus der WO 2009/106431 A2 ein Thermogenerator bekannt, der als Baueinheit mit einem Kollektor für eine thermische Solaranlage ausgebildet ist.

Die US 6 105 373 A offenbart eine thermoelektrische Vorrichtung mit einem thermoelektrische Schichten aufweisenden Substrat sowie Zuführmitteln, die ein Medium gegen einander gegenüberliegende Seiten des Substrats leitet.

Darüber hinaus offenbart die EP 1 729 195 A1 einen Heizkörperventil-Thermostataufsatz mit einer Betätigungseinrichtung, die mit einem Ventilelement zusammenwirkt, einem elektrischen Verbraucher sowie einer elektrischen Energieversorgungseinrichtung in Form eines thermoelektrischen Generators.

Zudem ist aus der GB 2 216 293 A eine Ventilsteuerung bekannt, die eine wiederaufladbare elektrische Energiequelle umfasst.

Das der vorliegenden Erfindung zugrunde liegende Problem besteht darin, eine thermoelektrische Vorrichtung zu schaffen, mit der auf einfache Weise thermische Energie eines Mediums in elektrische Energie umgewandelt werden kann.

Dieses Problem wird durch die thermoelektrische Vorrichtung mit den Merkmalen gemäß Anspruch 1 gelöst. Weiterbildungen der Erfindung sind in den abhängigen Ansprüchen angegeben.

Danach wird eine thermoelektrische Vorrichtung zum Erzeugen von elektrischer Energie bereitgestellt, mit
- einem Anschlusselement, das mit einem Ventil, welches zum Einstellen des Flusses eines Mediums dient und aus einem Ventilunterteil und einem Ventiloberteil besteht, verbindbar ist; und
- mindestens einem an dem Anschlusselement angeordneten Thermogenerator zum Umwandeln von thermischer Energie des Mediums in elektrische Energie, wobei
- das Anschlusselement erste Verbindungsmittel aufweist, über die es mit einem ersten Ventilelement in Form eines Ventilunterteils des Ventils verbindbar ist, sowie zweite Verbindungsmittel, über die es mit einem zweiten Ventilelement in Form eines Ventiloberteils des Ventils verbindbar ist, oder
- das Anschlusselement erste Verbindungsmittel aufweist, über die es mit einem ersten Ventilelement in Form eines ersten Bestandteils des Ventiloberteils verbindbar ist, sowie zweite Verbindungsmittel, über die es mit einem zweiten Ventilelement in Form eines zweiten Bestandteils des Ventiloberteils verbindbar ist.

Bei dem Medium handelt es sich insbesondere um ein temperiertes Medium (Gas oder Flüssigkeit), z.B. um ein Heizmedium, das in einen Heizkörper einströmt. Es ist jedoch auch denkbar, dass das Medium ein Kühlmedium (z.B. einer industriellen Produktionsanlage) ist, dessen Fluss über das Ventil eingestellt wird, und das einen Temperaturgradienten am Ort des Thermogenerators erzeugt.

Die erfindungsgemäße thermoelektrische Vorrichtung ist mittels des Anschlusselementes auf einfache Weise z.B. in ein bestehendes Heizungssystem (insbesondere in Form eines Raumheizungssystems) oder Kühlsystem integrierbar. Durch die Anordnung des Anschlusselementes zwischen den beiden Ventilelementen des Ventils befindet sich der Thermogenerator (bzw. eine Mehrzahl von Thermogeneratoren) zudem nah an dem Medium, so dass eine ausreichend effiziente Wandlung der thermischen Energie des Mediums in elektrische Energie möglich ist.

Das Ventil, mit dem das Anschlusselement verbunden werden kann, weist ein erstes Ventilelement in Form eines Ventiloberteils sowie ein zweites Ventilelement in Form eines Ventilkörpers (Ventilunterteils) auf, wobei der Ventilkörper insbesondere mit einer Leitung, über die das Medium geleitet, z.B. einem Heizkörper zugeführt, wird, verbunden ist und einen Kanal aufweist, über den das Medium, z.B. zum Heizkörper, fließt. Das Ventiloberteil weist einen bewegbaren Ventilstößel auf, der mit einem Absperrkörper (z.B. in Form eines "Ventiltellers") des Ventilunterteils zusammenwirkt, wobei der Absperrkörper in Abhängigkeit von der Stellung des Ventilstößels den Durchströmquerschnitt des Kanals des Ventilunterteils verändert. Insbesondere wird bei einem Bewegen des Ventilstößels auf den Ventilkörper zu der Durchfluss durch den Ventilkörper reduziert oder versperrt.

Die Bewegung des Ventilstößels kann z.B. dadurch erzeugt werden, dass das Ventiloberteil ein mit dem Ventilstößel zusammenwirkendes Ausdehnelement aufweist, das sich je nach Umgebungstemperatur mehr oder weniger stark ausdehnt und somit den Ventilstößel mehr oder weniger stark in Richtung auf das Ventilunterteil drückt. Das Ventiloberteil kann jedoch auch manuell bedienbar sein, wobei z.B. eine Drehung des Ventiloberteils eine Bewegung des Ventilstößels hervorruft. Es ist insbesondere auch möglich, dass der Ventilstößel über einen Elektromotor bewegt wird, wobei der Elektromotor z.B. über eine zentrale (d.h. separat zu dem Ventil angeordnete) Temperatursteuerung betrieben wird (insbesondere per Funk).

Gemäß einer Ausgestaltung der Erfindung weisen die ersten Verbindungsmittel zum Verbinden des Anschlusselementes mit dem ersten Ventilelement ein Gewinde auf, über das das erste Ventilelement mit dem Anschlusselement verschraubt werden kann. Des Weiteren können auch die zweiten Verbindungsmittel ein Gewinde aufweisen, über das das Anschlusselement mit dem zweiten Ventilelement koppelbar ist. Beispielsweise handelt es sich bei dem Gewinde der ersten Verbindungsmittel um ein Innengewinde und bei dem Gewinde der zweiten Verbindungsmittel um ein Außengewinde. Allerdings müssen die Verbindungsmittel nicht zwingend in Form von Gewinden ausgebildet sein, sondern es sind auch andere Arten von Verbindungsmitteln denkbar, z.B. Rastelemente oder sonstige Strukturen, die eine form- und/oder kraftschlüssige Verbindung zu den Ventilelementen zulassen. Das Anschlusselement kann somit auf einfache Weise mit einem vorhandenen Ventil gekoppelt und somit in ein bestehendes System integriert werden ("Retro-Fit").

Gemäß einer anderen Ausgestaltung der Erfindung weist die thermoelektrische Vorrichtung ein Übertragungselement auf, das mit einem Ventilstößel des zweiten Ventilelementes (des "Ventiloberteils") so zusammenwirken kann, dass es durch eine Bewegung des Ventilstößels in Bewegung versetzt wird und somit die Bewegung des Ventilstößels auf einen Absperrkörper des ersten Ventilelementes (des "Ventilunterteils") überträgt.

Insbesondere weist das Ventilunterteil ein Außengewinde auf, das in ein Innengewinde der ersten Verbindungsmittel eingeschraubt und somit mit dem Anschlusselement verbunden werden kann. Das Ventiloberteil kann ein Innengewinde oder eine Überwurfmutter mit einem Innengewinde aufweisen, über das es auf ein Außengewinde der zweiten Verbindungsmittel aufgeschraubt werden kann. Das Anschlusselement wird somit zwischen dem ersten und dem zweiten Ventilelement angeordnet, wobei jedoch mittels des Übertragungselementes die Funktionalität des Ventils voll erhalten bleibt.

Das Anschlusselement weist insbesondere einen Kanal auf, in der das Übertragungselement zumindest abschnittsweise geführt ist, so dass es im montierten Zustand der thermoelektrischen Vorrichtung (d.h. insbesondere, wenn das Anschlusselement mit dem ersten und dem zweiten Ventilelement verbunden ist) relativ zu dem Anschlusselement bewegbar ist. Insbesondere ist das Übertragungselement länglich (z.B. zylindrisch) ausgebildet, wobei es durch eine lineare Bewegung des Ventilstößels ebenfalls in eine lineare Bewegung versetzbar ist.

Gemäß der Erfindung weist das Anschlusselement mindestens einen Verbindungsbereich zum Verbinden mit dem Thermogenerator auf, an dem der Thermogenerator mit einer Seite anliegt. Die an dem Verbindungsbereich anliegende Seite des Thermogenerators ist dessen Heißseite, über die über das Anschlusselement zum Thermogenerator geleitete Wärme zur Kaltseite des Thermogenerators (die der Heißseite abgewandt ist) gelangt. Der Verbindungsbereich ist beispielsweise in Form einer Erhebung einer Außenseite des Anschlusselementes ausgeformt.

Um einen möglichst großen Temperaturgradienten zwischen Heiß- und Kaltseite des Thermogenerators zu erzeugen, kann an der Kaltseite des Thermogenerators eine Wärmesenke vorgesehen sein; beispielsweise in Form eines passiven oder aktiven Kühlkörpers. Insbesondere kann an der Kaltseite des Thermogenerators ein Rippenkühlkörper aus einem Metall (passive Kühlung) oder z.B. der kältere Rücklauf des Heizwassers (aktive Kühlung) angeordnet sein.

Als Kühlkörper kann insbesondere ein Körper mit einer hohen thermischen Masse (d.h. mit einer hohen Wärmekapazität, z.B. auch ein mit Wasser befüllter Hohlkörper) vorgesehen sein. Mit einem solchen Körper könnte für einen gewissen Zeitraum ab Einwirkung der Wärmeenergie des Mediums ein erhöhter Temperaturgradient über den Thermogenerator und damit eine erhöhte Thermogeneratorspannung erzeugt werden. Insbesondere könnte die kurzzeitig erhöhte Thermogeneratorspannung ausreichen, um eine DC-Booster-Schaltung (s.u.) zum Anschwingen zu bringen.

Das Anschlusselement selber ist insbesondere aus einem Metall (d. h. aus einem gut wärmeleitenden Material) gebildet, beispielsweise aus Aluminium. Das Material und die Struktur des Anschlusselementes sind insbesondere so beschaffen, dass Wärme von dem Medium möglichst effizient an den Thermogenerator geleitet werden kann.

Des Weiteren kann die erfindungsgemäße thermoelektrische Vorrichtung einen Anschluss aufweisen, über den die vom Thermogenerator erzeugte elektrische Energie einem Verbraucher zugeführt werden kann. Der Anschluss (z. B. ein Stecker) ist z. B. eine in das Anschlusselement integrierte Steckkupplung oder eine von dem Thermogenerator oder einer elektronischen Schaltung zum Betrieb des Thermogenerators weg führende elektrische Leitung. Insbesondere weist die elektrische Leitung ein Kupplungselement auf, über das sie mit einem entsprechenden Kupplungselement des Ventils (insbesondere eines Ventiloberteils) verbindbar ist. Beispielsweise handelt es sich bei dem Kupplungselement der elektrischen Leitung um einen Standardstecker, der in eine Standardanschlussbuchse (die z.B. zum Anschließen eines Netzteils dient) des Ventils eingesteckt werden kann.

Um ein Ventil, das konventionell über eine Batterie versorgt wird, mit elektrischer Energie des Thermogenerators der erfindungsgemäßen Vorrichtung versorgen zu können, ist es darüber hinaus denkbar, dass das Kupplungselement einen Batteriefachadapter aufweist (bzw. aus dem Batteriefachadapter besteht), der anstelle einer Batterie in ein Batteriefach des Ventils einsetzbar ist. Ein derartiger mit einem Thermogenerator verbundener Batteriefachadapter ist in der deutschen Patentanmeldung DE 10 2010 029 090.4 vom 18.05.2010 beschrieben, auf die insofern hiermit ausdrücklich Bezug genommen wird.

Möglich ist natürlich auch, dass das Anschlusselement über eine spezielle Kupplung mit dem Ventil verbunden wird, d.h. das Anschlusselement weist ein proprietäres Kupplungselement auf, das mit einem entsprechenden propritären Kupplungselement des Ventils verbunden werden kann. Beispielsweise sind die propritären Kupplungselemente so gestaltet, dass mit dem mechanischen Verbinden des Anschlusselementes mit dem Ventil auch eine Verbindung der Kupplungselemente erfolgt. Denkbar ist z.B. auch, dass die Kupplung, d.h. das thermogeneratorseitige und das ventilseitige Kupplungselement, nach Montage des Anschlusselementes an dem Ventil von außen nicht sichtbar ist.

Gemäß der Erfindung sind das Anschlusselement und das zweite Ventilteil (bei dem es sich um ein Ventiloberteil handelt) in einem gemeinsamen Gehäuse untergebracht. Das gemeinsame Gehäuse kann z.B. dadurch realisiert werden, dass das Anschlusselement ein erstes Gehäuse und das zweite Ventilteil ein zweites Gehäuse besitzen, wobei das erste und das zweite Gehäuse bei der Montage des Anschlusselementes an dem zweiten Ventilteil miteinander verbunden werden, z.B. über entsprechende Raststrukturen. Der elektrische Kontakt zwischen dem Thermogenerator des Anschlusselementes und dem zweiten Ventilteil wird z.B. über die erwähnten propritären Kupplungselemente hergestellt.

Denkbar ist auch, dass sowohl das erste als auch das zweite Ventilteil, zwischen denen das Anschlusselement eingesetzt werden soll, jeweils ein Bestandteil eines Ventiloberteils sind, wobei beispielsweise das erste Ventilteil Mittel zum Verbinden mit einem Ventilunterteil aufweist. Beispielsweise weist das erste Ventilteil ein erstes Gehäuseteil und das zweite Ventilteil ein zweites Gehäuseteil auf, wobei das erste und das zweite Gehäuseteil miteinander (z.B. lösbar) verbunden werden können, um ein gemeinsames Gehäuse des Ventiloberteils zu realisieren. Möglich ist, dass das Anschlusselement in das Gehäuseteil des ersten oder zweiten Ventilteils integrierbar ist, so dass es sich nach einem Verbinden der beiden Gehäuseteile im Innern des gebildeten gemeinsamen Gehäuses befindet. Denkbar ist auch, dass das Anschlusselement ebenfalls ein Gehäuseteil aufweist, das mit dem jeweiligen Gehäuseteil des ersten und des zweiten Ventilteils verbindbar ist, z.B. per Rastverbindung.

Der Verbraucher, der über den Anschluss des Anschlusselementes mit dem Thermogenerator verbunden ist, ist z. B. eine Komponente des mit dem Anschlusselement gekoppelten Ventils (d.h. insbesondere eine Komponente eines der beiden Ventilelemente) selber. Beispielsweise weist das zweite Ventilelement einen Elektromotor auf, der mit der elektrischen Energie des Thermogenerators versorgt wird. Des Weiteren ist denkbar, dass das Ventil funkgesteuert ist und Funkkomponenten des Ventils oder einer Ventilsteuerung mit der Thermogeneratorenergie gespeist werden. Möglich ist auch, dass zusätzlich oder alternativ zu dem Ventil andere Komponenten eines Heizungssystems über die Thermogeneratorspannung versorgt werden.

Beispielsweise könnte eine Vorrichtung zur Ermittlung des Energieverbrauchs ("Heizkostenverteiler") in der Nähe der thermoelektrischen Vorrichtung angebracht werden, um sie mit der Thermogeneratorspannung versorgen zu können. Hier ist denkbar, dass das Modell, über das aus den Messdaten des Heizkostenverteilers (i.a. die verdunstete Menge einer Flüssigkeit) auf den Verbrauch geschlossen wird, an diese Position des Heizkostenverteilers angepasst wird.

Es ist auch denkbar, dass der an dem Anschlusselement angeordnete Thermogenerator (insbesondere in Kombination mit einem Kühlkörper) als Heizkostenverteiler genutzt wird. Hierzu werden insbesondere die Temperaturen an der Heiß- und der Kaltseite des Thermogenerators ermittelt und in Abhängigkeit von diesen Temperaturen und dem thermischen Widerstand des Kühlkörpers und des Thermogenerators sowie des Heizungstyps (z.B. dessen Abmessungen) der Energieverbrauch bestimmt. Darüber hinaus kann das Anschlusselement eine Regelungselektronik aufweisen oder mit einer solchen verbunden sein, die in Abhängigkeit von dem ermittelten Momentanverbrauch das Ventil steuert; z.B. bei einem Thermostatkopf, dessen Stellelement per Elektromotor betrieben wird, ein Steuersignal an den Elektromotor übermittelt.

Darüber hinaus kann die thermoelektrische Vorrichtung auch Mittel zum Speichern der vom Thermogenerator erzeugten elektrischen Energie aufweisen, z. B. in Form einer elektrischen Schaltung und/oder eines Kondensators. Beispielsweise sind die Mittel zum Speichern der elektrischen Energie in das Anschlusselement integriert oder an dem Anschlusselement angeordnet.

Es ist auch denkbar, dass die thermoelektrische Vorrichtung Mittel zum Konvertieren der vom Thermogenerator erzeugten elektrischen Spannung aufweist, die z. B. ebenfalls an dem Anschlusselement angeordnet sein können. Die Mittel zum Konvertieren der Thermogeneratorspannung umfassen z. B. eine DC-Booster-Schaltung (Gleichspannungserhöhungsschaltung) zum Erhöhen der vom Thermogenerator erzeugten Spannung. Die DC-Booster-Schaltung ist z. B. in Form eines elektronischen Schaltkreises realisiert, der insbesondere ebenfalls an dem Anschlusselement angeordnet oder in das Anschlusselement integriert ist. Beispielsweise ist die DC-Booster-Schaltung zusammen mit den erwähnten Mitteln zum Speichern der Thermogeneratorenergie auf einer Leiterplatte angeordnet.

Die Erfindung betrifft auch ein Heiz- oder Kühlsystem mit der erfindungsgemäßen thermoelektrischen Vorrichtung.

Die Erfindung wird im Folgenden anhand von Ausführungsbeispielen unter Bezugnahme auf die Figuren näher erläutert. Es zeigen:
- Fig. 1A und 1B: Ansichten einer thermoelektrischen Vorrichtung gemäß einem Ausführungsbeispiel der Erfindung vor Montage der Thermogeneratoren an dem Anschlusselement;
- Fig. 2A und 2B: die thermoelektrische Vorrichtung aus den Figuren 1A und 1B nach Montage der Thermogeneratoren;
- Fig. 3A und 3B: das Anschlusselement der thermoelektrischen Vorrichtung aus den Figuren 1A und 1B in perspektivischer Darstellung; und
- Fig. 4A bis 4C: Ansichten der an einem Heizungsventil montierten thermoelektrischen Vorrichtung aus den Figuren 2A und 2B.

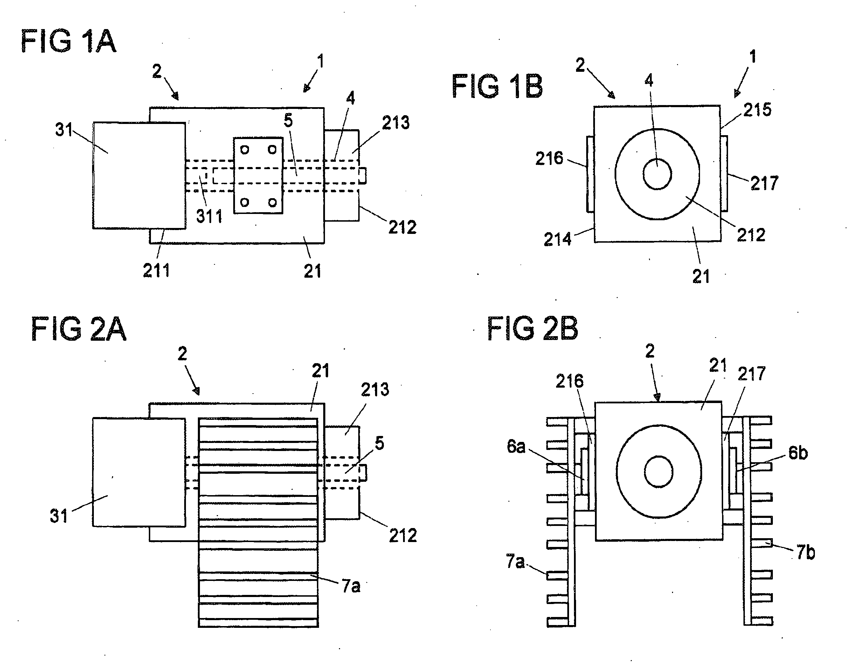

Die Figuren 1A und 1B zeigen die thermoelektrische Vorrichtung 1 in Seitenansicht (Figur 1 A) bzw. in Vorderansicht (Figur 1 B). Die dargestellte thermoelektrische Vorrichtung 1 umfasst ein Anschlusselement 2, das nach Art eines Adapters mit einem Ventil, das zum Einstellen eines Flusses eines Heizmediums in einen Heizkörper (nicht dargestellt) dient, verbunden werden kann. Das Ventil weist ein erstes Vertilelement in Form eines Ventilunterteils 31 sowie ein zweites Ventilelement in Form eines Ventiloberteils (nicht dargestellt) auf.

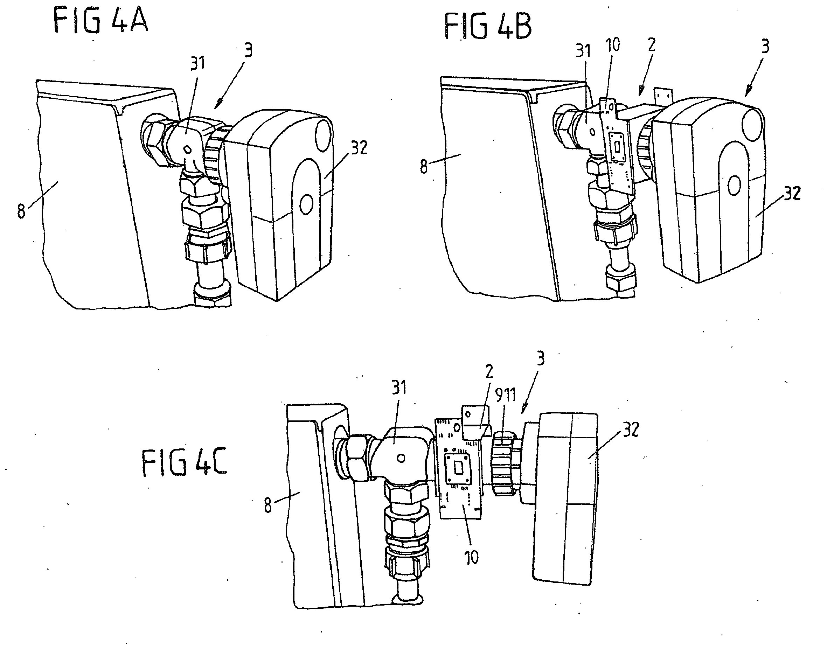

Das Anschlusselement 2 umfasst einen zumindest näherungsweise quaderförmigen Grundkörper 21, der an einer Stirnseite 2100 eine Bohrung 2101 mit einem Innengewinde 211 (beispielsweise ein M30-Gewinde) aufweist, in das das Ventilunterteil 31 eingeschraubt ist. An einer der Stirnseite 2100 gegenüberliegenden Stirnseite 2200 des Grundkörpers 21 befindet sich ein zylindrischer Ansatz 212 mit einem Außengewinde 213 (z.B. ebenfalls ein M30-Gewinde), das zur Kopplung des Anschlusselementes 2 mit dem Ventiloberteil dient; vgl. die Figuren 4B und 4C.

An zwei einander gegenüberliegenden und senkrecht zu den Stirnseiten 2100 und 2200 orientierten Seitenflächen 214, 215 des Grundkörpers 21 ist jeweils ein als Erhebung (mit rechteckiger Kontur) der Seitenflächen 214, 215 ausgeformter Verbindungsbereich 216, 217 vorgesehen, über den ein Thermogenerator (in Figuren 1A und 1B nicht dargestellt) mit dem Grundkörper 21 des Anschlusselementes 2 verbunden werden kann. Die Verbindungsbereiche 216, 217 weisen darüber hinaus Bohrungen 2161 mit einem Innengewinde auf, über die eine Wärmesenke (vgl. Figuren 2A, 2B) mit dem Grundkörper 21 des Anschlusselementes 2 verbunden werden kann.

Des Weiteren weist das Anschlusselement 2 einen Kanal in Form einer Durchgangsbohrung 4 auf, die sich parallel zu den Seitenflächen 214, 215 und zwischen den Stirnseiten 2100 und 2200 erstreckt. Über die Stirnseite 2100 ragt ein stiftartiges Teilstück 311 eines Absperrkörpers zum Einstellen des Querschnitts eines in dem Ventilunterteil ausgebildeten Kanals, durch den das Heizmedium strömt, in die Durchgangsbohrung 4 hinein. Im Inneren der Durchgangsbohrung 4 befindet sich ein Übertragungselement in Form eines Übertragungsstiftes 5.

Der Übertragungsstift 5 wirkt so mit einem Ventilstößel (nicht dargestellt) eines über das Gewinde 214 mit dem Anschlusselement 2 gekoppelten Ventiloberteils zusammen, dass bei einer Bewegung des Ventilstößels auf das Ventilunterteil 31 zu dieses gegen den Stift 311 drückt, wodurch der Absperrkörper des Ventilunterteils 31 den Durchströmquerschnitt des Ventilunterteils reduziert oder ganz verschließt. Umgekehrt wird der Stift 311 (insbesondere über eine Feder) unter Vorspannung gehalten, so dass eine Bewegung des Ventilstößels von dem Ventilunterteil 31 weg ein Nachfolgen des Übertragungsstiftes 5 und des Stiftes 311 und somit eine Vergrößerung oder vollständige Öffnung des Durchströmquerschnitt des Ventilunterteils bewirkt. Somit wird eine Bewegung des Ventilstößels bei Zwischenschalten des Anschlusselementes 5 zwischen das Ventilunter- und das Ventiloberteil nicht mehr unmittelbar auf den Absperrkörper des Ventilkörpers übertragen, sondern über eine Bewegung des Übertragungsstiftes 5.

Die Figuren 2A und 2B zeigen die Anordnung der Figuren 1A und 1B, wobei an den Verbindungsbereichen 216, 217 jeweils ein Thermogenerator 6a, 6b angeordnet ist. Bei den Thermogeneratoren 6a, 6b handelt es sich um mikrotechnologisch hergestellte Thermogeneratoren, die jeweils mit ihrer Heißseite mit einer Außenseite des Grundkörpers 21 (d.h. mit einer Außenseite der Verbindungsbereiche 216, 217) des Anschlusselementes 2 verbunden sind. Die Kaltseite der Thermogeneratoren 6a, 6b ist jeweils mit einer Wärmesenke in Form eines großflächigen Rippenkühlkörpers 7a, 7b verbunden, um eine möglichst gute Wärmeabfuhr von der Kaltseite der Thermogeneratoren 6a, 6b und damit einen möglichst großen Temperaturgradienten über den jeweiligen Thermogenerator 6a, 6b zu erzeugen. Die Kühlkörper 7a, 7b sind über (insbesondere hohlzylindrische) Abstandselemente 71 mit dem Anschlusselement verbunden (insbesondere über die in den Fig. 1A und 1B gezeigten Bohrungen 2161).

Die Thermogeneratoren 6a, 6b werden durch Verschrauben des jeweiligen Kühlkörpers 7a, 7b mit dem Anschlusselement 2 gegen den Verbindungsbereich 216, 217 gepresst und dadurch einerseits mit den Kühlkörpern 7a, 7b und andererseits mit dem Verbindungsbereich 216, 217 des Anschlusselementes 2 verbunden und thermisch gekoppelt. Zwischen der Kaltseite der Thermogeneratoren 6a, 6b und dem Kühlkörper 7a, 7b sowie zwischen der Heißseite der Thermogeneratoren und dem Verbindungsbereich 216, 217 ist jeweils ein gut wärmeleitendes Interface-Material (Grenzschichtmaterial), z.B. in Form einer gut wärmeleitenden Folie, insbesondere einer Graphitfolie, angeordnet, um einen möglichst guten Wärmeübergang von den Thermogeneratoren zum Kühlkörper bzw. zum Anschlusselement 2 zu schaffen.

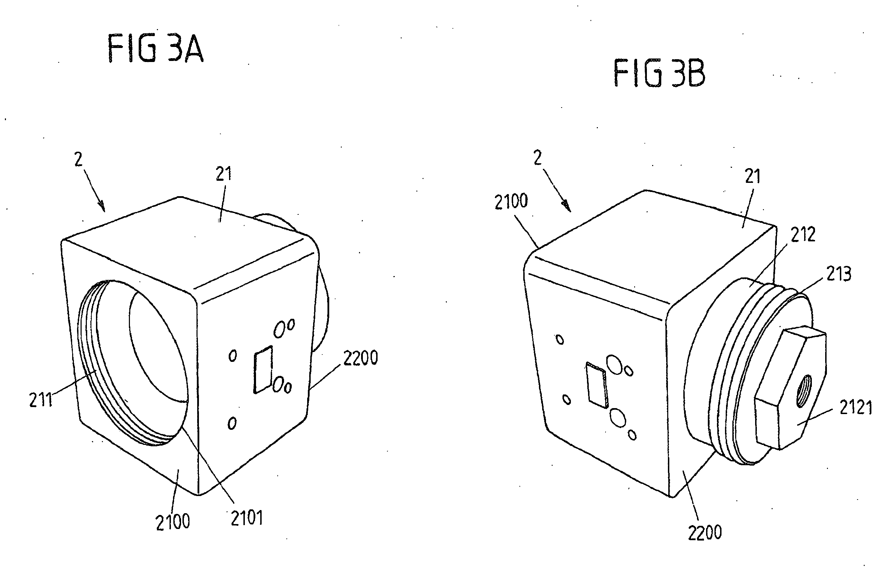

Die Figuren 3A und 3B zeigen das aus einem Stück hergestellte Anschlusselement 2 der vorhergehenden Figuren in perspektivischer Darstellung (ohne Ventilelemente und Thermogeneratoren). Es wird darauf hingewiesen, dass das Anschlusselement zwar einen quaderförmigen Grundkörper 21 aufweist. Die Erfindung ist jedoch selbstverständlich nicht auf eine bestimmte Geometrie des Anschlusselementes limitiert, sondern die Form des Anschlusselementes kann im Prinzip beliebig gewählt werden, z.B. auch zylindrisch.

Die Figuren 4A bis 4C beziehen sich auf die Montage der thermoelektrischen Vorrichtung an einem Heizkörper, wobei Figur 4A einen Heizkörper 8 darstellt, an dem lediglich ein Ventil 3 zum Einstellen der Zulaufmenge des Heizmediums in den Heizkörpers angeordnet ist, jedoch noch keine thermoelektrische Vorrichtung gemäß der Erfindung. Das Ventil 3 besteht aus einem Ventiloberteil 32, das mit Hilfe einer Überwurfmutter 911 auf ein Ventilunterteil 31 aufgeschraubt ist.

Die erfindungsgemäße thermoelektrische Vorrichtung 1 wird nun so montiert, dass ihr Anschlusselement 2 sowohl mit dem Ventilunterteil 31 als auch mit dem Ventiloberteil 32 verbunden wird, d.h. das Anschlusselement 2 wird zwischen diesen Ventilelementen angeordnet. Gemäß den Figuren 4B, 4C ist das Ventilunterteil 31 in das Innengewinde 211 (Fig. 3A) des Anschlusselementes 2 eingeschraubt. Auf der dem Innengewinde 211 abgewandten Seite des Anschlusselementes 2 ist das Ventiloberteil 32 mittels der Überwurfmutter 911, die auf das Außengewinde 213 des Anschlusselementes 2 aufgeschraubt ist, mit dem Anschlusselement gekoppelt.

An den Seitenflächen des Anschlusselementes 2, die die Verbindungsbereiche 216, 217 für die Thermogeneratoren aufweisen, ist gemäß den Figuren 4B, 4C jeweils eine Leiterplatte 10 vormontiert, während die Thermogeneratoren noch nicht montiert sind. Die Leiterplatten 10 weisen jeweils eine Aussparung im Bereich der Verbindungsbereiche 216, 217 auf, so dass die Verbindungsbereiche einschließlich der Bohrungen zum Befestigen eines Kühlkörpers (vergleiche Figur 2B) von außen zugänglich sind.

Die Leiterplatten 10 weisen insbesondere Strukturen auf, die als Abstandshalter zwischen dem Kühlkörper und dem Anschlusselement 2 dienen können; vgl. Figur 2B. Darüber hinaus sind auf den Leiterplatten jeweils z.B. Mittel zur Aufbereitung der vom Thermogenerator jeweils erzeugten elektrischen Spannung, insbesondere einer DC-Booster-Schaltung angeordnet. Des Weiteren ist ein elektrischer Anschluss vorgesehen, über den die aufbereitete Spannung einem elektrischen Verbraucher zugeführt werden kann.

Vorliegend weist das Ventiloberteil 32 einen Elektromotor zum Bewegen des Ventilstößels auf, der zumindest teilweise mittels der von den Thermogeneratoren erzeugten elektrischen Energie betrieben werden kann. Hierzu kann über einen Anschluss auf der Leiterplatte 10 die (aufbereitete) Thermogeneratorspannung dem Elektromotor bzw. einer Betriebschaltung zum Betreiben des Elektromotors zugeführt werden.

Für den Fall, dass der Elektromotor des Ventiloberteils über eine oder mehrere in dem Ventiloberteil angeordnete Batterie(n) betrieben wird, ist auch denkbar, dass die Thermogeneratorspannung über einen Batteriefachadapter zugeführt wird. Ein derartiger Batteriefachadapter weist einen an die Abmessungen eines Batteriefachs angepassten Kontakt auf, der anstelle von Batterien (bzw. zumindest einer Batterie) in das Batteriefach des Ventiloberteils eingesetzt werden kann, um die vom Thermogenerator erzeugte elektrische Spannung einzuspeisen. Ein in Frage kommender Batteriefachadapter ist, wie bereits oben erwähnt, in der deutschen Patentanmeldung DE 10 2010 029 090.4 beschrieben.

### Bezugszeichenliste

- 1: thermoelektrische Vorrichtung
- 2: Anschlusselement
- 3: Ventil
- 4: Durchgangsbohrung
- 5: Übertragungsstift
- 6a, 6b: Thermoelement
- 7a, 7b: Kühlkörper
- 8: Heizkörper
- 10: Leiterplatte
- 21: Grundkörper
- 31: Ventilunterteil
- 32: Ventiloberteil
- 71: Abstandselement
- 211: Innengewinde
- 212: Ansatz
- 213: Außengewinde
- 214, 215: Seitenfläche
- 216, 217: Verbindungsbereich
- 311: Stift
- 911: Überwurfmutter
- 2100,2200: Stirnseite
- 2101: Bohrung

## Patentansprüche

1. Thermoelektrische Vorrichtung zum Erzeugen von elektrischer Energie, mit
- einem Anschlusselement (2), das mit einem Ventil (3), welches zum Einstellen des Flusses eines Mediums dient und aus einem Ventilunterteil (31) und einem Ventiloberteil (32) besteht, verbindbar ist; und
- mindestens einem an dem Anschlusselement (2) angeordneten Thermogenerator (6a, 6b) zum Umwandeln von thermischer Energie des Mediums in elektrische Energie, wobei das Anschlusselement (2) mindestens einen Verbindungsbereich (216, 217) aufweist, an dem der Thermogenerator (6a, 6b) mit einer Seite anliegt,
**dadurch gekennzeichnet, dass**
das Anschlusselement (2) erste Verbindungsmittel (211) aufweist, über die es mit einem ersten Ventilelement (31) in Form des Ventilunterteils des Ventils (3) verbindbar ist, sowie zweite Verbindungsmittel (213), über die es mit einem zweiten Ventilelement (32) in Form des Ventiloberteils des Ventils (3) verbindbar ist, wobei das Anschlusselement (2) ein erstes Gehäuse und das Ventiloberteil ein zweites Gehäuse besitzen, wobei das erste und das zweite Gehäuse zur Realisierung eines gemeinsamen Gehäuses bei der Montage des Anschlusselements (2) an dem Ventiloberteil miteinander verbunden werden, oder
das Anschlusselement (2) erste Verbindungsmittel (211) aufweist, über die es mit einem ersten Ventilelement (31) in Form eines ersten Bestandteils des Ventiloberteils verbindbar ist, sowie zweite Verbindungsmittel (213), über die es mit einem zweiten Ventilelement (32) in Form eines zweiten Bestandteils des Ventiloberteils verbindbar ist.

2. Thermoelektrische Vorrichtung nach Anspruch 1, **dadurch gekennzeichnet, dass** die ersten Verbindungsmittel (211) ein erstes Gewinde aufweisen, über das das erste Ventilelement (31) mit dem Anschlusselement (2) gekoppelt werden kann, und die zweiten Verbindungsmittel (213) ein zweites Gewinde, über das das Anschlusselement (2) mit dem zweiten Ventilelement (32) gekoppelt werden kann.

3. Thermoelektrische Vorrichtung nach einem der vorhergehenden Ansprüche, **gekennzeichnet durch** ein Übertragungselement (5), das mit einem Ventilstößel des zweiten Ventilelements (32) so zusammenwirken kann, dass es durch eine Bewegung des Ventilstößels in Bewegung versetzt wird und die Bewegung des Ventilstößels auf einen Absperrkörper des ersten Ventilelementes (31) überträgt.

4. Thermoelektrische Vorrichtung nach Anspruch 3, **dadurch gekennzeichnet, dass** das Übertragungselement (5) in einem Kanal (4) des Anschlusselementes (2) zumindest abschnittsweise so geführt ist, dass es nach Kopplung des Anschlusselementes (2) mit dem zweiten Ventilelement (32) relativ zu dem Anschlusselement (2) bewegbar ist.

5. Thermoelektrische Vorrichtung nach einem der vorhergehenden Ansprüche, **dadurch gekennzeichnet, dass** der Verbindungsbereich (216, 217) als Erhebung einer Außenseite des Anschlusselementes (2) ausgebildet ist

6. Thermoelektrische Vorrichtung nach einem der vorhergehenden Ansprüche, **gekennzeichnet durch** eine Wärmesenke (7a, 7b), die mit einer dem Anschlusselement (2) abgewandten Seite des Thermogenerators (6a, 6b) in thermischem Kontakt steht.

7. Thermoelektrische Vorrichtung nach Anspruch 6, **dadurch gekennzeichnet, dass** die Wärmesenke (7a, 7b) an dem Anschlusselement (2) festgelegt ist.

8. Thermoelektrische Vorrichtung nach einem der vorhergehenden Ansprüche, **dadurch gekennzeichnet, dass** das Anschlusselement (2) aus einem Metall, insbesondere aus Aluminium, einer Legierung und/oder einem Composite-Material gebildet ist.

9. Thermoelektrische Vorrichtung nach einem der vorhergehenden Ansprüche, **gekennzeichnet durch** einen Anschluss, über den die von dem Thermogenerator (6a, 6b) erzeugte elektrische Energie einem Verbraucher zugeführt werden kann.

10. Thermoelektrische Vorrichtung nach einem der vorhergehenden Ansprüche, **gekennzeichnet durch** eine mit dem Thermogenerator (6a, 6b) elektrisch verbundene elektrische Leitung, die ein Kupplungselement aufweist, über das sie mit einem entsprechenden Kupplungselement des Ventils (3) verbindbar ist.

11. Thermoelektrische Vorrichtung nach Anspruch 10, **dadurch gekennzeichnet, dass** das Kupplungselement einen Batteriefachadapter aufweist, der anstelle einer Batterie in ein Batteriefach des Ventils (3) einsetzbar ist.

12. Thermoelektrische Vorrichtung nach einem der vorhergehenden Ansprüche, **gekennzeichnet durch** Mittel zum Speichern der von dem Thermogenerator (6a, 6b) erzeugten elektrischen Energie.

13. Thermoelektrische Vorrichtung nach einem der vorhergehenden Ansprüche, **gekennzeichnet durch** Mittel zum Konvertieren der vom Thermogenerator (6a, 6b) erzeugten elektrischen Spannung, insbesondere in Form einer DC-Booster-Schaltung zum Erhöhen der vom Thermogenerator (6a, 6b) erzeugten Spannung.

## Claims

1. Thermoelectric device for generating electrical energy, having
- a connection element (2) which can be connected to a valve (3) which serves to adjust the flow of a medium and consists of a valve lower part (31) and a valve upper part (32); and
- at least one thermogenerator (6a, 6b), which is arranged on the connection element (2), for converting thermal energy of the medium into electrical energy, wherein the connection element (2) has at least one connecting region (216, 217) against which the thermogenerator (6a, 6b) bears by way of one side,
**characterized in that**
the connection element (2) has first connecting means (211) by means of which it can be connected to a first valve element (31) in the form of the valve lower part of the valve (3), and also has second connecting means (213) by means of which it can be connected to a second valve element (32) in the form of the valve upper part of the valve (3), wherein the connection element (2) has first housing and the valve upper part has a second housing, wherein, in order to implement a common housing, the first and the second housing are connected to each other when fitting the connecting element (2) onto the valve upper part or
the connection element (2) has first connecting means (211) by means of which it can be connected to a first valve element (31) in the form of a first constituent part of the valve upper part, and also has second connecting means (213) by means of which it can be connected to a second valve element (32) in the form of a second constituent part of the valve upper part.

2. Thermoelectric device according to Claim 1, **characterized in that** the first connecting means (211) have a first thread by means of which the first valve element (31) can be coupled to the connection element (2), and the second connecting means (213) have a second thread by means of which the connection element (2) can be coupled to the second valve element (32).

3. Thermoelectric device according to any of the preceding claims, **characterized by** a transmission element (5) which can interact with a valve tappet of the second valve element (32) such that it is made to move by a movement of the valve tappet and transmits the movement of the valve tappet to a blocking body of the first valve element (31).

4. Thermoelectric device according to Claim 3, **characterized in that** the transmission element (5) is arranged in a channel (4) of the connection element (2) at least in sections such that it can move relative to the connection element (2) after the connection element (2) is coupled to the second valve element (32).

5. Thermoelectric device according to any of the preceding claims, **characterized in that** the connecting region (216, 217) is in the form of a raised portion of an outer face of the connection element (2).

6. Thermoelectric device according to any of the preceding claims, **characterized by** a heat sink (7a, 7b) which is in thermal contact with a side of the thermogenerator (6a, 6b) facing away from the connection element (2).

7. Thermoelectric device according to Claim 6, **characterized in that** the heat sink (7a, 7b) is fixed to the connection element (2).

8. Thermoelectric device according to any of the preceding claims, **characterized in that** the connection element (2) is formed from a metal, in particular from aluminium, an alloy and/or a composite material.

9. Thermoelectric device according to any of the preceding claims, **characterized by** a connection by means of which the electrical energy which is generated by the thermogenerator (6a, 6b) can be supplied to a load.

10. Thermoelectric device according to any of the preceding claims, **characterized by** an electrical line which is electrically connected to the thermogenerator (6a, 6b) and has a coupling element by means of which it can be connected to a corresponding coupling element of the valve (3).

11. Thermoelectric device according to Claim 10, **characterized in that** the coupling element has a battery compartment adapter which can be inserted into a battery compartment of the valve (3) instead of a battery.

12. Thermoelectric device according to any of the preceding claims, **characterized by** means for storing the electrical energy which is generated by the thermogenerator (6a, 6b).

13. Thermoelectric device according to any of the preceding claims, **characterized by** means for converting the electrical voltage which is generated by the thermogenerator (6a, 6b), in particular in the form of a DC booster circuit for increasing the voltage which is generated by the thermogenerator (6a, 6b).

## Revendications

1. Dispositif thermoélectrique servant à produire une énergie électrique, comprenant :
- un élément de raccordement (2) qui peut être relié à une soupape (3), qui sert à ajuster le flux d'un milieu et qui est constituée d'une partie inférieure de soupape (31) et d'une partie supérieure de soupape (32) ; et
- au moins un thermogénérateur (6a, 6b) disposé au niveau de l'élément de raccordement (2) servant à convertir de l'énergie thermique du milieu en une énergie électrique, où l'élément de raccordement (2) présente au moins une zone de liaison (216, 217), au niveau de laquelle repose le thermogénérateur (6a, 6b) par un coté,
**caractérisé en ce**
**que** l'élément de raccordement (2) présente des premiers moyens de liaison (211), par l'intermédiaire desquels il peut être relié au premier élément de soupape (31) se présentant sous la forme de la partie inférieure de soupape de la soupape (3), ainsi que des deuxièmes moyens de liaison (213), par l'intermédiaire desquels il peut être relié à un deuxième élément de soupape (32) se présentant sous la forme de la partie supérieure de soupape de la soupape (3), l'élément de raccordement (2) comportant un premier boîtier et la partie supérieure de soupape comportant un second boîtier, les premier et second boîtiers étant reliés l'un à l'autre afin de réaliser un boîtier commun lorsque l'élément de raccordement (2) est monté sur la partie supérieure de soupape, ou
**en ce que** l'élément de raccordement (2) présente des premiers moyens de liaison (211), par l'intermédiaire desquels il peut être relié au premier élément de soupape (31) se présentant sous la forme d'un premier composant de la partie supérieure de soupape, ainsi que des deuxièmes moyens de liaison (213), par l'intermédiaire desquels il peut être relié à un deuxième élément de soupape (32) se présentant sous la forme d'un deuxième composant de la partie supérieure de soupape.

2. Dispositif thermoélectrique selon la revendication 1, **caractérisé en ce que** les premiers moyens de liaison (211) présente un premier filetage, par l'intermédiaire duquel le premier élément de soupape (31) peut être couplé à l'élément de raccordement (2), et **en ce que** les deuxièmes moyens de liaison (213) présentent un deuxième filetage, par l'intermédiaire duquel l'élément de raccordement (2) peut être couplé au deuxième élément de soupape (32).

3. Dispositif thermoélectrique selon l'une quelconque des revendications précédentes, **caractérisé par** un élément de transmission (5), qui peut coopérer avec un poussoir de soupape du deuxième élément de soupape (32) de telle manière qu'il est amené en mouvement par un déplacement du poussoir de soupape et transfère le déplacement du poussoir de soupape sur un corps d'arrêt du premier élément de soupape (31).

4. Dispositif thermoélectrique selon la revendication 3, **caractérisé en ce que** l'élément de transmission (5) est guidé dans un canal (4) de l'élément de raccordement (2) au moins par endroits de telle manière qu'il peut être déplacé, après le couplage de l'élément de raccordement (2) au deuxième élément de soupape (32), par rapport à l'élément de raccordement (2).

5. Dispositif thermoélectrique selon l'une quelconque des revendications précédentes, **caractérisé en ce que** la zone de liaison (216, 217) est réalisée sous la forme d'une bosse d'un côté extérieur de l'élément de raccordement (2).

6. Dispositif thermoélectrique selon l'une quelconque des revendications précédentes, **caractérisé par** un dissipateur thermique (7a, 7b), qui est en contacte thermique avec un côté, opposé à l'élément de raccordement (2), du thermogénérateur (6a, 6b).

7. Dispositif thermoélectrique selon la revendication 6, **caractérisé en ce que** le dissipateur thermique (7a, 7b) est fixé au niveau de l'élément de raccordement (2).

8. Dispositif thermoélectrique selon l'une quelconque des revendications précédentes, **caractérisé en ce que** l'élément de raccordement (2) est formé à partir d'un métal, en particulier à partir d'aluminium, d'un alliage et/ou d'un matériau composite.

9. Dispositif thermoélectrique selon l'une quelconque des revendications précédentes, **caractérisé par** un raccordement, par l'intermédiaire duquel l'énergie électrique produite par le thermogénérateur (6a, 6b) peut être amenée à un consommateur.

10. Dispositif thermoélectrique selon l'une quelconque des revendications précédentes, **caractérisé par** une ligne électrique reliée de manière électrique au thermogénérateur (6a, 6b), laquelle présente un élément de couplage, par l'intermédiaire duquel elle peut être reliée à un élément d'accouplement correspondant de la soupape (3).

11. Dispositif thermoélectrique selon la revendication 10, **caractérisé en ce que** l'élément d'accouplement présente un adaptateur de compartiment de batterie, qui peut être inséré dans un compartiment de batterie de la soupape (3) en lieu et place d'une batterie.

12. Dispositif thermoélectrique selon l'une quelconque des revendications précédentes, **caractérisé par** des moyens servant à stocker l'énergie électrique produite par le thermogénérateur (6a, 6b).

13. Dispositif thermoélectrique selon l'une quelconque des revendications précédentes, **caractérisé par** des moyens servant à convertir la tension électrique produite par le thermogénérateur (6a, 6b), se présentant en particulier sous la forme d'un survolteur CC servant à augmenter la tension produite par le thermogénérateur (6a, 6b).
